# FASCICULE DE BREVET EUROPEEN

(11) **EP 4 127 737 B1**
(45) Date de publication et mention de la délivrance du brevet: **10.01.2024**
(21) Numéro de dépôt: 21732364.1
(22) Date de dépôt: 24.03.2021
(51) Int. Cl.: G01R 15/18

(54) **CAPTEUR DE COURANT DE TYPE ROGOWSKI RAPIDE ET IMMUNE AUX DERIVES EN TENSION**
SCHNELLER UND SPANNUNGSDRIFTUNEMPFINDLICHER ROGOWSKI-STROMSENSOR
ROGOWSKI CURRENT SENSOR WHICH IS FAST AND IMMUNE TO VOLTAGE DRIFTS

(30) Priorité: 02.04.2020 FR 2003329
(43) Date de publication de la demande: 08.02.2023
(73) Titulaire: Safran Electrical & Power, 31702 Blagnac (FR)
(72) Inventeur: CIMA, Lionel, 77550 Moissy-Cramayel (FR)
(74) Mandataire: Cabinet Beau de Loménie
(86) Numéro de dépôt international: PCT/FR2021/050505
(87) Numéro de publication internationale: WO 2021/198590

(56) Documents cités:
- EP-A1- 1 596 205
- US-A1- 2014 333 290

## Description

### Domaine Technique

L'invention concerne la mesure de courant circulant dans un conducteur, et plus particulièrement la mesure de courant en haute fréquence par des dispositifs de type Rogowski.

### Technique antérieure

Pour mesurer des courants en haute fréquence, typiquement au-delà de 10 kHz, on peut utiliser des capteurs à fibre optique reposant sur l'effet Faraday. Néanmoins, ces capteurs sont relativement encombrants et nécessitent d'entourer de nombreuses fois le conducteur dans lequel circule le courant à mesurer. De plus, ils ne sont pas capables de mesurer de faibles courants (quelques ampères).

Il existe également des capteurs de courant de type transformateur de courant qui permettent d'assurer une séparation galvanique entre le mesurant et la mesure. Pour des mesures en haute fréquence, il est nécessaire d'avoir un noyau de perméabilité relative élevée, ce qui les rend sensibles aux courants continus qui vont saturer le noyau magnétique et ainsi dégrader la mesure. Ces capteurs sont également encombrants et de masse élevée.

EP 1 596 205 A1 divulgue un transformateur de courant à bobinages de type Rogowski, comportant des circuits partiels associés pour former un circuit complet. Les spires des enroulements de la bobine Rogowski de chaque circuit partiel sont enroulées dans le même sens de manière à former un seul enroulement présentant une paire de terminaisons électriques adjacentes. Les paires de terminaisons électriques des enroulements sont connectées à un système d'acquisition désigné pour produire un signal complet représentant le courant primaire du transformateur.

US 2014/333290 A1 divulgue un capteur à bobine Rogowski, destiné à être utilisé dans un compteur d'électricité polyphasé. Il est doté d'un noyau non magnétique comprenant un enroulement de bobine avec prise centrale et un circuit de rejet de mode commun couplé à l'enroulement à la tension de référence de référence.

Les capteurs de courant de type Rogowski permettent également de mesurer des courants à haute fréquence. Ces capteurs permettent de déterminer la valeur d'un courant circulant dans un conducteur à partir d'une tension générée par le courant dans des bobines à air ou à noyau faiblement magnétique voire amagnétique, la tension générée étant proportionnelle à la dérivée temporelle du courant. Ce type de capteur est relativement compact et insensible aux composantes continues du courant du fait de l'absence de noyau magnétique dans la bobine. La précision en température de ce type de capteur dépend de l'impédance de charge ; il ne faut pas que la dérive thermique de la résistance interne du capteur soit trop importante par rapport à la résistance de charge. On utilise donc des résistances de charge élevées, qui sont généralement 100 fois plus élevées que la résistance interne du capteur, qui entraînent de fortes résonnances en haute fréquence dans les capteurs. Cela dégrade les mesures voire sature l'électronique en cas de forte vitesse de variation en courant.

De plus, pour s'immuniser contre les variations rapides de la tension du conducteur, l'utilisation d'un écran électrostatique n'est pas souhaitable, car cela réduit la bande passante du capteur.

Il est donc souhaitable de disposer d'un dispositif de mesure de courant compact et adapté aux hautes fréquences, typiquement au-delà de 10 kHz, c'est-à-dire étant adapté à des temps de commutation rapides, typiquement inférieurs à 10 µs, tout en étant immunisé aux variations rapides de tension, de courant et aux dérives en température.

### Exposé de l'invention

L'invention concerne un circuit électrique de mesure d'un courant circulant dans un conducteur comprenant :
- 2xN bobines, N étant un entier supérieur ou égal à 2, reliées en série entre elles ; et
- un élément de filtrage d'un mode commun associé à chacune des 2xN bobines, chaque élément de filtrage étant placé en parallèle de la bobine associée et étant apte à réaliser un filtrage de mode commun des 2xN bobines,
un noyau des 2xN bobines ayant une perméabilité relative inférieure à 10, et parmi les 2xN bobines, N bobines étant enroulées dans un sens opposé au sens d'enroulement des N autres bobines.

On entend par bobine un dipôle de forme annulaire constitué par au moins un enroulement multi-spires délimitant un espace interne de la bobine. L'espace interne de la bobine est ainsi l'espace de mesure autour du conducteur, dans lequel circule le courant à mesurer, délimité par les enroulements multi-spires des bobines.

L'utilisation des 2xN bobines, avec N supérieur ou égal à 2, permet d'améliorer la réjection du mode commun des bobines grâce aux éléments de filtrage mis en parallèle des 2xN bobines. En effet, en haute fréquence, les éléments de filtrage de mode commun sont capacitifs. Donc, la capacité de mode commun (capacité équivalente des éléments de filtrage) qui permet d'atténuer le courant en sortie des 2xN bobines est équivalente à la capacité formée par l'ensemble des éléments de filtrage mis en parallèle. Tandis que la capacité de mode différentiel qui limite la bande passante est équivalente à la capacité formée par l'ensemble des éléments de filtrage reliés entre eux en série. Si on note C0 la capacité d'un seul élément de filtrage et que l'on considère que les éléments de filtrage sont identiques, la capacité de mode commun sera 2xNxC0 et la capacité de mode différentiel sera C0/(2×N). Donc en augmentant le nombre de bobines, on augmente le nombre d'éléments de filtrage, ce qui permet d'augmenter la capacité de mode commun pour améliorer la réjection du mode commun tout en diminuant la capacité de mode différentiel pour ne pas restreindre la bande passante.

On utilise un nombre pair de bobines, dans lequel la moitié des bobines est enroulée dans un sens et l'autre moitié en sens opposé. Cela permet de réaliser un multipôle dans lequel le signal utile, c'est-à-dire la force électromotrice due au couplage magnétique entre le courant circulant dans le conducteur et les bobines, apparaît en mode différentiel ; tandis que le signal parasite, c'est-à-dire la tension due au couplage capacitif entre le potentiel du conducteur et les bobines, apparaît en mode commun. Cela permet également, du fait que le noyau des bobines soit faiblement magnétique (perméabilité relative inférieure à 10), d'avoir un circuit équivalent à une bobine de type Rogowski comprenant 2xN enroulements. Ainsi, on peut déterminer un courant circulant dans un conducteur de la même manière qu'une bobine de type Rogowski. En plaçant les enroulements des 2xN bobines autour d'un conducteur, dont on souhaite mesurer le courant, on génère une tension proportionnelle à la dérivée temporelle dudit courant dans les bobines. En récupérant cette tension aux bornes des 2xN bobines, on peut donc déterminer le courant dans le conducteur par intégration.

Selon un mode de réalisation, le circuit électrique comprend au moins un anneau de garde entourant les 2xN bobines et les éléments de filtrage et reliant les éléments de filtrage à une masse électrique.

L'utilisation d'au moins un anneau de garde permet d'améliorer la réjection du mode commun. En entourant les 2xN bobines et les éléments de filtrage, l'anneau de garde ceinture le circuit et assure une protection vis-à-vis des champs forts (protection de compatibilité électromagnétique, dite protection « CEM »). Il permet également de relier à la masse électrique les éléments de filtrage grâce à une piste dédiée à cela.

Selon une caractéristique particulière de l'invention, les éléments de filtrage sont des condensateurs à trois terminaux, par exemple ceux développés selon la technologie X2Y^{®}.

Les condensateurs de technologie X2Y^{®} sont des condensateurs céramiques qui permettent de réduire les coûts et d'améliorer les performances de filtrage, car ces condensateurs sont plus compacts, moins coûteux et supportent des fréquences plus élevées que les condensateurs traditionnels.

Selon une autre caractéristique particulière de l'invention, le circuit comprend un câble de liaison disposant d'une tresse de blindage reliée aux 2xN bobines.

Quand on utilise un anneau de garde, celui-ci peut également être relié à la tresse de blindage du câble de liaison. Grâce à la tresse de blindage, le circuit présente une bonne immunité aux perturbations « CEM ».

Selon une autre caractéristique particulière de l'invention, le câble de liaison est une paire torsadée blindée dont l'impédance caractéristique est chargée par une résistance R placée en parallèle, le câble de liaison étant placé entre la résistance en parallèle et l'ensemble formé par les 2xN bobines et les éléments de filtrage.

Si la résistance R est faible, c'est-à-dire elle est telle que l'inverse de la constante de temps L/R soit inférieure à la fréquence du courant à mesurer, L étant l'inductance de l'ensemble des 2xN bobines, on récupère aux bornes de cette résistance une tension directement proportionnelle au courant circulant dans le conducteur grâce à un effet d'auto-intégration.

Selon un mode de réalisation, le circuit électrique comprend également une charge, la charge étant placée entre les N bobines enroulées dans un même sens et les N autres bobines enroulées en sens opposé.

Cette charge permet de réaliser une adaptation d'impédance pour éliminer les réflexions en très haute fréquence et ainsi assurer une augmentation de la bande passante malgré la présence d'une ligne de transmission de longue distance. Le circuit de mesure se comporte ainsi comme une ligne de transmission et permet de transporter un signal utile sur une longue distance sans déformation en mode différentiel, tandis que les courants de perturbation du mode commun sont filtrés par les éléments de filtrage grâce à la forte capacité équivalente.

Selon une caractéristique particulière de l'invention, la charge est une résistance inférieure ou égale à 100 Ohms, en particulier inférieure ou égale à 75 Ohms, et encore plus particulièrement inférieure ou égale à 50 Ohms.

Selon une autre caractéristique particulière de l'invention, les 2xN bobines ne comprennent qu'une couche de spires. Cela permet d'augmenter la bande passante du circuit de mesure.

Selon un mode de réalisation, le circuit électrique comprend un intégrateur dont des entrées sont reliées aux 2xN bobines.

L'intégrateur permet d'intégrer le signal en sortie des 2xN bobines, notamment la tension générée dans les bobines par la circulation du courant dans le conducteur, pour déterminer le courant circulant dans ledit conducteur. Les entrées de l'intégrateur sont reliées aux 2xN bobines pour réaliser une mesure différentielle du courant circulant dans le conducteur.

Selon une autre caractéristique particulière de l'invention, l'intégrateur est un montage intégrateur à amplificateur opérationnel.

Selon une autre caractéristique particulière de l'invention, les 2xN bobines et les éléments de filtrage sont présents sur au moins un support souple.

Selon une autre caractéristique particulière de l'invention, les 2xN bobines et les éléments de filtrage sont présents sur au moins un circuit imprimé. Le circuit imprimé est un support particulièrement adapté au nombre élevé de bobines du circuit de mesure.

Un autre objet de l'invention est un capteur de courant comprenant un circuit électrique selon l'invention.

Selon une caractéristique particulière de l'invention, le capteur comprend un conducteur, les 2xN bobines étant enroulées autour du conducteur. Cela permet notamment de mesurer un courant circulant dans une pièce conductrice ou dans un composant électrique ou dans un circuit électrique sans placer cette pièce ou composant ou circuit dans l'enroulement des 2xN bobines grâce au conducteur du capteur qui est relié à cette pièce, composant ou circuit.

### Brève description des dessins

D'autres caractéristiques et avantages de la présente invention ressortiront de la description faite ci-dessous, en référence aux dessins annexés qui en illustrent des exemples de réalisation dépourvus de tout caractère limitatif.
[Fig. 1] La figure 1 représente, de manière schématique et partielle, un circuit électrique de mesure d'un courant selon un mode de réalisation de l'invention.
[Fig. 2] La figure 2 représente, de manière schématique et partielle, un circuit électrique de mesure d'un courant selon un autre mode de réalisation de l'invention.
[Fig. 3] La figure 3, représente, de manière schématique et partielle, un circuit électrique de mesure d'un courant selon un autre mode de réalisation de l'invention.

### Description des modes de réalisation

Comme indiqué précédemment, on entend par bobine un dipôle de forme annulaire constitué par au moins un enroulement multi-spires délimitant un espace interne de la bobine ainsi que l'espace de mesure autour du conducteur.

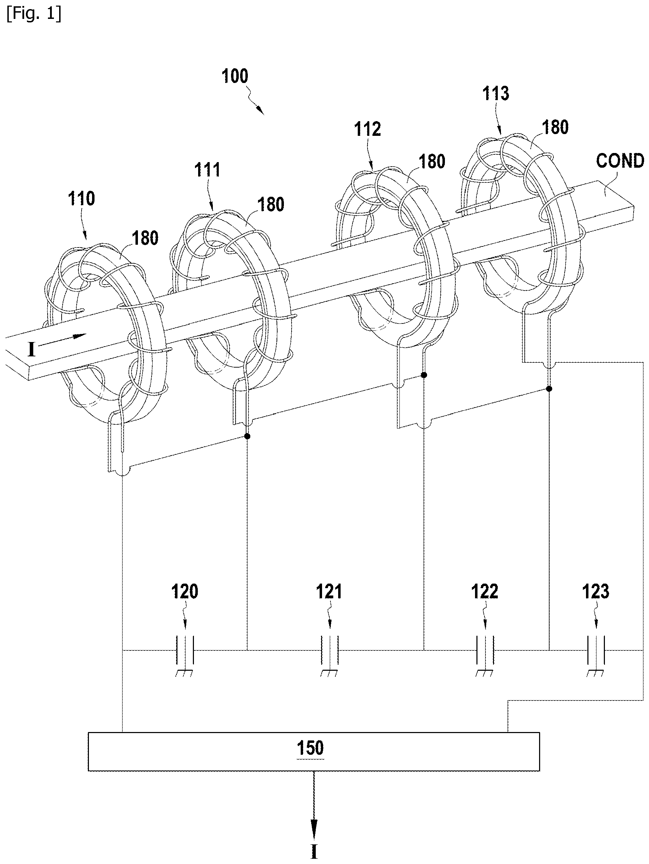

La figure 1 représente, de manière schématique et partielle, un circuit électrique de mesure 100 d'un courant I circulant dans un conducteur COND selon un mode de réalisation de l'invention. Ce circuit 100 comprend quatre bobines 110, 111, 112 et 113 qui sont destinées à être enroulées autour du conducteur COND. Les quatre bobines 110, 111, 112 et 113 sont reliées entre elles en série. Leur noyau 180 présente une perméabilité relative inférieure à 10, leurs noyaux 180 sont donc faiblement magnétiques. Ils peuvent également être amagnétiques. Les bobines 110 à 113 peuvent également être des bobines à air, dans ce cas, leur noyau 180 ne sera formé que d'air.

Les deux bobines 110 et 111 sont enroulées dans un premier sens et les deux autres bobines 112 et 113 sont enroulées en sens opposé. Cela permet de rejeter les couplages capacitifs entre le potentiel du conducteur COND et les bobines 110 à 113.

Des éléments de filtrage 120, 121, 122 et 123 des modes communs des bobines 110 à 113 sont également présents dans le circuit 100. Un élément de filtrage est placé en parallèle de chaque bobine. Ainsi, l'élément de filtrage 120 est placé en parallèle de la bobine 110, l'élément de filtrage 121 est placé en parallèle de la bobine 111, l'élément de filtrage 122 est placé en parallèle de la bobine 112 et l'élément de filtrage 123 est placé en parallèle de la bobine 113. En mode commun, le montage des éléments de filtrage 120 à 123 apparaît ainsi comme une mise en parallèle des éléments de filtrage 120 à 123 et en mode différentiel, leur montage apparaît comme une mise en série des mêmes éléments. Cela permet d'améliorer la réjection du mode commun des bobines 110 à 113 sans dégrader la bande passante du circuit de mesure 100.

Comme le noyau 180 des bobines 110 à 113 est faiblement magnétique, que les bobines 110 à 113 sont enroulées autour du conducteur COND dans lequel circule le courant I à mesurer et que la moitié des bobines 110 et 111 est enroulée dans un sens et l'autre moitié 112 et 113 dans un autre sens, l'ensemble des quatre bobines 110 à 113 forme une bobine de type Rogowski. La circulation du courant I dans le conducteur COND génère donc une tension dans les bobines 110 à 113 qui est proportionnelle à la dérivée du courant I. Ainsi pour déterminer la valeur du courant I, on peut intégrer la tension générée dans les bobines 110 à 113. Pour cela, le circuit 100 comprend un moyen de traitement 150 de la tension générée par les bobines 110 à 113. Ce moyen de traitement 150 est par exemple un moyen d'intégration, placé en sortie des bobines 110 à 113 et de leurs éléments de filtrage 120 à 123 associés.

Selon une caractéristique particulière de l'invention, les éléments de filtrage 120 à 123 sont des éléments capacitifs, et plus particulièrement sont des condensateurs en céramique X2Y^{®}. L'utilisation de condensateurs X2Y^{®} permet de réaliser un circuit de mesure 100 moins coûteux, plus compact et pouvant supporter des fréquences plus élevées qu'un circuit réalisé avec des condensateurs traditionnels.

Par ailleurs, en notant C0 la capacité des condensateurs X2Y ^{®}, la capacité de mode commun, c'est-à-dire la capacité équivalente des éléments de filtrage en mode commun, est égale à 4xC0. Les éléments de filtrage permettent donc d'atténuer significativement le courant de perturbation du mode commun en sortie de l'ensemble des bobines 110 à 113 et des éléments de filtrage 120 à 123. La capacité de mode différentiel est égale à C0/4, le courant de perturbation du mode différentiel est donc réduit.

Selon une autre caractéristique particulière de l'invention, le circuit 100 comprend 2xN bobines avec N un entier supérieur ou égal à 2. Parmi les 2xN bobines, N bobines sont enroulées dans un premier sens et les N autres bobines sont enroulées dans le sens opposé. L'augmentation du nombre de bobines permet d'augmenter également le nombre d'éléments de filtrage en parallèle des bobines, et donc d'améliorer la réjection du mode commun. En effet, avec 2xN bobines, la capacité équivalente en mode commun sera égale à 2xNxC0 tandis que la capacité équivalente en mode différentiel sera égale à C0/(2×N). La perturbation de mode commun en sortie de l'ensemble des bobines et des éléments de filtrage sera donc réduite significativement, tandis que le signal utile (en mode différentiel) sera faiblement affecté.

Selon une autre caractéristique particulière de l'invention, les bobines 110 à 113 comprennent des spires réparties sur une seule couche, c'est-à-dire qu'elles comprennent une seule couche d'enroulement multi-spires.

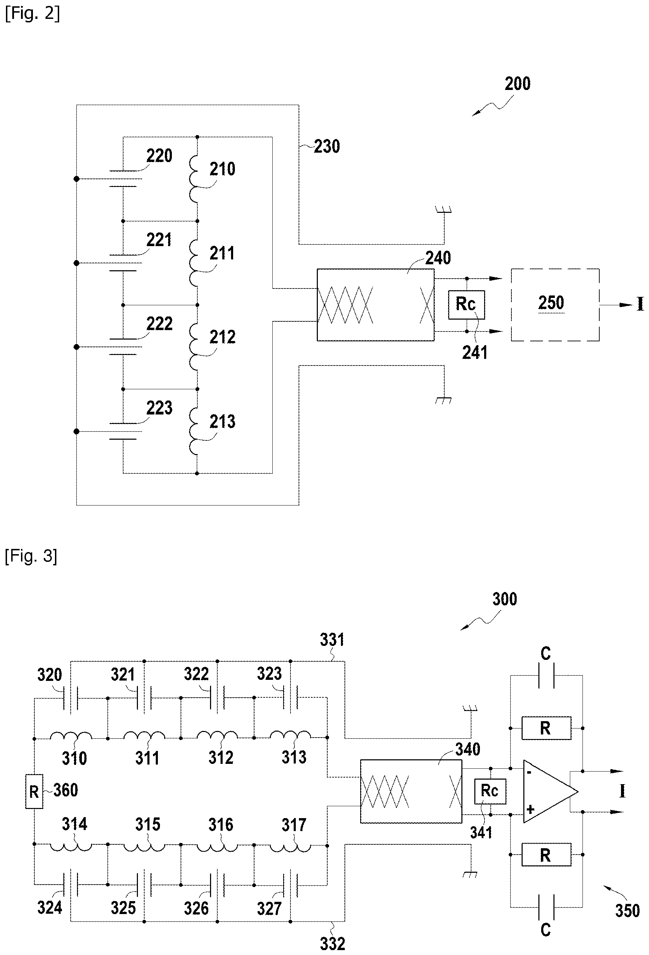

La figure 2 représente, de manière schématique et partielle, un circuit électrique 200 de mesure d'un courant I selon un autre mode de réalisation de l'invention.

Le circuit 200 comprend quatre bobines 210, 211, 212 et 213 reliées en série et reliée chacune en parallèle à un élément de filtrage 220, 221, 222 et 223 de mode commun des bobines 210 à 213. Comme décrit précédemment, le noyau des bobines 210 à 213 est faiblement magnétique, c'est-à-dire que la perméabilité relative de son noyau est inférieure à 10, voire à 2, voire à 1,1. Deux des quatre bobines sont enroulées dans un premier sens et les deux autres en sens opposé. Les bobines créent ainsi un dispositif de type Rogowski pour mesurer un courant circulant dans un conducteur. Pour des raisons de clarté de la figure, le conducteur n'est pas représenté sur la figure 2.

Le circuit 200 comprend également un anneau de garde 230 relié à une masse électrique et entourant les éléments de filtrage 220 à 223 et les bobines 210 à 213. Chaque élément de filtrage 220 à 223 est relié à l'anneau de garde 230, et sont ainsi reliés à la masse électrique. En les entourant l'anneau de garde 230 permet de distribuer de façon homogène les éléments de filtrage 220 à 223 et ainsi de protéger les bobines 210 à 213 des perturbations électromagnétiques. Il permet également de mettre à la masse les éléments de filtrage 220 à 223 grâce à une piste dédiée. Il améliore ainsi la réjection du mode commun.

Le circuit 200 comprend également un câble de liaison 240 comprenant une tresse de blindage qui permet d'éliminer les réflexions de l'éventuelle électronique 250, qui détermine le courant I que l'on souhaite mesurer, vers les bobines 210 à 213 et les éléments de filtrage 220 à 223.

Selon une caractéristique particulière de l'invention, le câble de liaison 240 est une paire torsadée blindée dont l'impédance caractéristique est chargée par une résistance 241 placée en parallèle. La résistance 241 est placée à la sortie du câble de liaison 240.

Selon une autre caractéristique particulière de l'invention, l'anneau de garde 230 entoure également le câble de liaison 240.

Selon une autre caractéristique particulière de l'invention, la valeur de la résistance 241 est faible, c'est-à-dire qu'elle est telle que l'inverse de la constance de temps L/R soit inférieure à la fréquence du courant à mesurer, avec R la valeur de la résistance 241 et L l'inductance des 2xN bobines. Cela permet d'obtenir en sortie de la tresse de blindage du câble de liaison 240 et de la résistance 241 un courant directement proportionnel au courant I que l'on souhaite mesurer dans le conducteur. Ainsi, l'éventuelle électronique 250 reliée au circuit de mesure 200, qui permet de déterminer la valeur du courant I circulant dans le conducteur, ne réalise aucune fonction d'intégration pour déterminer le courant I.

La figure 3, représente, de manière schématique et partielle, un circuit électrique 300 de mesure d'un courant I circulant dans un conducteur selon un autre mode de réalisation de l'invention. Pour des raisons de clarté de la figure, le conducteur n'est pas représenté sur la figure 3.

Le circuit 300 comprend huit bobines 310 à 317. Les bobines 310 à 313 sont enroulées dans un premier sens et les bobines 314 à 317 sont enroulées en sens opposé. Une résistance 360 sépare ces deux groupes de bobines. Les bobines 310 à 313 sont reliées entre elles en série et sont reliées à la résistance 360 en série. Les bobines 314 à 317 sont reliées entre elles en série et sont reliées à la résistance 360 en série. Un élément de filtrage de mode commun 320 à 327 est placé en parallèle de chacune des bobines 310 à 317.

Le noyau des bobines 310 à 317 est faiblement magnétique, donc sa perméabilité relative est inférieure à 10. Comme indiqué précédemment, les bobines 310 à 317 forment un dispositif de type Rogowski.

Le circuit 300 comprend un câble de liaison 340 comprenant une tresse de blindage reliée aux bobines 310 à 317 ainsi qu'une résistance 341 placée en parallèle de la tresse de blindage. Un intégrateur 350 est présent dans le circuit à la suite de la résistance 341. L'intégrateur 350 est plus particulièrement un montage intégrateur à amplificateur opérationnel qui permet de déterminer la valeur du courant I. Les entrées de l'intégrateur sont reliées aux bobines 310 à 317 par la résistance 341 et la tresse de blindage du câble de liaison 340, pour réaliser une mesure du courant I de manière différentielle.

La résistance 360 permet d'obtenir en sortie du câble de liaison 340 et de sa résistance parallèle 341 (et en sortie des bobines 310 à 317) un signal sur une faible impédance. L'électronique 350 peut donc présenter une faible impédance. La valeur de la résistance 360 est par exemple de 100 Ohms.

Le circuit 300 comprend également deux anneaux de garde 331 et 332 entourant les bobines 310 à 317, les éléments de filtrage 320 à 327 et le câble de liaison 340. Les deux anneaux de garde 331 et 332 sont reliés à une masse électrique. L'anneau de garde 331 est relié aux éléments de filtrage 320 à 323 et relie ces éléments à la masse électrique. L'anneau de garde 332 est relié aux éléments de filtrage 324 à 327 et relie ces éléments à la masse électrique.

Selon une autre caractéristique particulière de l'invention, les bobines et les éléments de filtrage du mode commun des bobines sont présents sur au moins un support souple.

Selon une autre caractéristique particulière de l'invention, les bobines et les éléments de filtrage du mode commun des bobines sont présents sur au moins un circuit imprimé. Le circuit imprimé est un support particulièrement adapté au nombre important de bobines pour réaliser un circuit de mesure compact.

L'invention concerne également un capteur de courant comprenant un circuit de mesure tel que décrit précédemment. Le conducteur dans lequel circule le courant à mesurer est placé dans l'enroulement des bobines du circuit de mesure.

Selon une caractéristique particulière de l'invention, le capteur comprend un conducteur placé dans l'enroulement des bobines. De cette manière, si l'on souhaite mesurer le courant circulant dans une pièce conductrice ou dans un composant électrique ou un circuit électrique externe au capteur et/ou ne pouvant être placé dans l'enroulement des bobines, il suffit de relier cette pièce, composant ou circuit au conducteur du capteur, de manière à ce que le courant circulant dans cette pièce, composant ou circuit circule également dans le conducteur du capteur.

## Revendications

1. Circuit électrique de mesure (100, 200, 300) d'un courant (I) circulant dans un conducteur (COND) comprenant :
- 2xN bobines (110 à 113, 210 à 213, 310 à 317), N étant un entier supérieur ou égal à 2, reliées en série entre elles ; et
- un élément de filtrage (120 à 123, 220 à 223, 320 à 327) d'un mode commun associé à chacune des 2xN bobines, chaque élément de filtrage étant placé en parallèle de la bobine associée et étant apte à réaliser un filtrage de mode commun des 2xN bobines,
un noyau (180) des 2xN bobines ayant une perméabilité relative inférieure à 10, et parmi les 2xN bobines, N bobines étant enroulées dans un sens opposé au sens d'enroulement des N autres bobines.

2. Circuit électrique selon la revendication 1 dans lequel les 2xN bobines ne comprennent qu'une couche de spires.

3. Circuit électrique selon la revendication 1 ou 2 comprenant au moins un anneau de garde (230, 331, 332) entourant les 2xN bobines et les éléments de filtrage et reliant les éléments de filtrage à une masse électrique.

4. Circuit électrique selon l'une quelconque des revendications 1 à 3 dans lequel les éléments de filtrage sont des condensateurs à trois électrodes.

5. Circuit électrique selon l'une quelconque des revendications 1 à 4 comprenant également un câble de liaison (240, 340) comprenant une tresse de blindage relié aux 2xN bobines.

6. Circuit électrique selon l'une quelconque des revendications 1 à 5 comprenant également une charge (360), la charge étant placée entre les N bobines (310 à 313) enroulées dans un même sens et les N autres bobines (314 à 317) enroulées en sens opposé.

7. Circuit électrique selon l'une quelconque des revendications 1 à 6 comprenant un intégrateur (350) dont des entrées sont reliées aux 2xN bobines.

8. Circuit électrique selon l'une quelconque des revendications 1 à 7 dans lequel lesdites 2xN bobines et lesdits éléments de filtrage sont présents sur au moins un circuit imprimé.

9. Capteur de courant comprenant un circuit électrique selon l'une quelconque des revendications 1 à 8.

10. Capteur de courant selon la revendication 9 comprenant un conducteur, les 2xN bobines étant enroulées autour dudit conducteur.

## Patentansprüche

1. Elektrische Schaltung zur Messung (100, 200, 300) eines Stroms (I), der in einem Leiter (COND) zirkuliert, umfassend:
- 2xN Spulen (110 bis 113, 210 bis 213, 310 bis 317), die untereinander in Reihe geschaltet sind, wobei N eine ganze Zahl größer oder gleich 2 ist, und
- ein Gleichtakt-Filterelement (120 bis 123, 220 bis 223, 320 bis 327), das einer jeden der 2xN Spulen zugeordnet ist, wobei jedes Filterelement parallel zu der zugeordneten Spule platziert und dazu geeignet ist, eine Gleichtaktfilterung der 2xN Spulen durchzuführen,
wobei ein Kern (180) der 2xN Spulen eine relative Permeabilität von weniger als 10 aufweist, und unter den 2xN Spulen N Spulen in einer Richtung gewickelt sind, die der Wickelrichtung der N anderen Spulen entgegengesetzt ist.

2. Elektrische Schaltung nach Anspruch 1, wobei die 2xN Spulen nur eine Lage von Wicklungen umfassen.

3. Elektrische Schaltung nach Anspruch 1 oder 2, umfassend zumindest einen Schutzring (230, 331, 332), der die 2xN Spulen und die Filterelemente umgibt und die Filterelemente mit einer elektrischen Masse verbindet.

4. Elektrische Schaltung nach einem der Ansprüche 1 bis 3, wobei die Filterelemente Kondensatoren mit drei Elektroden sind.

5. Elektrische Schaltung nach einem der Ansprüche 1 bis 4, ferner umfassend ein Verbindungskabel (240, 340), das eine Abschirmlitze umfasst und mit den 2xN Spulen verbunden ist.

6. Elektrische Schaltung nach einem der Ansprüche 1 bis 5, ferner umfassend eine Last (360), wobei die Last zwischen den N Spulen (310 bis 313), die in einer selben Richtung gewickelt sind, und den N anderen Spulen (314 bis 317), die in der entgegengesetzten Richtung gewickelt sind, platziert ist.

7. Elektrische Schaltung nach einem der Ansprüche 1 bis 6, umfassend einen Integrator (350), dessen Eingänge mit den 2xN Spulen verbunden sind.

8. Elektrische Schaltung nach einem der Ansprüche 1 bis 7, wobei die 2xN Spulen und die Filterelemente auf zumindest einer gedruckten Schaltung vorliegen.

9. Stromsensor, umfassend eine elektrische Schaltung nach einem der Ansprüche 1 bis 8.

10. Stromsensor nach Anspruch 9, umfassend einen Leiter, wobei die 2xN Spulen um den Leiter herum gewickelt sind.

## Claims

1. An electrical circuit for measuring (100, 200, 300) a current (I) flowing in a conductor (COND), comprising:
- 2xN coils (110 to 113, 210 to 213, 310 to 317), N being an integer greater than or equal to 2, connected in series together; and
- a common mode filtering element (120 to 123, 220 to 223, 320 to 327) associated with each of the 2xN coils, each filtering element being placed in parallel with the associated coil and being able to accomplish common mode filtering of the 2xN coils,
a core (180) of the 2xN coils having a relative permeability less than 10, and among the 2xN coils, N coils being wound in a direction opposite to the winding direction of the other N coils.

2. The electrical circuit according to claim 1, wherein the 2xN coils comprise only one layer of turns.

3. The electrical circuit according to claim 1 or 2, comprising at least one guard ring (230, 331, 332) surrounding the 2xN coils and the filtering elements and connecting the filtering elements to an electrical ground.

4. The electrical circuit according to any one of claims 1 to 3, wherein the filtering elements are three-electrode capacitors.

5. The electrical circuit according to any one of claims 1 to 4, also comprising a connecting cable (240, 340) comprising a shielding braid connected to the 2xN coils.

6. The electrical circuit according to any one of claims 1 to 5, also comprising a load (360), the load being placed between the N coils (310 to 313) wound in the same direction and the N other coils (314 to 317) wound in the opposite direction.

7. An electrical circuit according to any one of claims 1 to 6, comprising an integrator (350) the inputs of which are connected to the 2xN coils.

8. The electrical circuit according to any one of claims 1 to 7, wherein said 2xN coils and said filtering elements are present on at least one printed circuit.

9. A current sensor comprising an electrical circuit according to any one of claims 1 to 8.

10. A current sensor according to claim 9 comprising a conductor, the 2xN coils being wound around said conductor.
